# DEMANDE DE BREVET EUROPEEN

(11) **EP 0 596 773 A1**
(43) Date de publication de la demande: **11.05.1994**
(21) Numéro de dépôt: 93402627.9
(22) Date de dépôt: 26.10.1993
(51) Int. Cl.: G01R 1/067

(54) **Dispositif pour tests hyperfréquences à large bande réalisés in situ**

(30) Priorité: 03.11.1992 FR 9213152
(71) Demandeur: THOMSON-CSF, 75008 Paris (FR)
(72) Inventeur: Cachier, Gérard, F-92402 Courbevoie Cedex (FR)
(74) Mandataire: Benoit, Monique

(57) **Abrégé**

L'invention concerne un dispositif pour tests hyperfréquences à large bande réalisés in situ.

Ce dispositif comporte un support (21a) dont la face inférieure, destinée à être au-dessus de la ligne hyperfréquence (12) à tester, est munie de moyens de couplage hyperfréquence (20) captant l'onde électromagnétique rayonnée par la ligne, ces moyens de couplage (20) étant recouverts d'une partie isolante (21b) dont l'épaisseur est telle qu'elle permet le couplage hyperfréquence entre les moyens de couplage (20) et la ligne (12) lorsque le dispositif est posé directement sur la ligne (12).

Le dispositif comporte en outre des moyens d'extraction (22, 24) d'un signal caractéristique de l'onde prélevée par les moyens de couplage.

L'invention s'applique aux tests in situ de circuits hyperfréquences, notamment en ondes millimétriques.

## Description

L'invention concerne un dispositif permettant de faire des tests hyperfréquences réalisés in situ, c'est-à-dire en des points arbitraires d'un circuit hybride ou monolithique fonctionnant dans la gamme des hyperfréquences.

Les circuits hybrides ou monolithiques permettent de réaliser des fonctions hyperfréquences complexes qui nécessitent d'être testées à différents niveaux. Cette nécessité provient de la nature intrinsèquement analogique de ces circuits, laquelle entraîne automatiquement des gabarits de réalisation resserrés. Ce besoin est particulièrement critique en hyperfréquences car les longueurs d'onde considérées entraînent un accroissement correspondant de la sensibilité des circuits aux dimensions.

Par ailleurs, les performances demandées aux fonctions hyperfréquences (puissance, facteur de bruit, linéarité, bande passante et caractéristiques de filtrage, précision des modulations, ...) conditionnent directement celles de l'équipement intégrateur et doivent par conséquent être garanties de façon la plus précise possible. Le caractère précurseur de beaucoup de composants hyperfréquences, utilisés parfois en limites de performances, accentue le besoin de tests hyperfréquences.

Jusqu'à présent, on a l'habitude de tester avant montage les composants actifs (diodes, transistors, circuits intégrés) en les faisant travailler en continu, en fonction d'un gabarit donné, et ce dans les phases maquette, prototype et série. Les circuits intégrés peuvent aussi être testés en hyperfréquences grâce à des machines de test sous pointes comme celles vendues par CASCADE MICROWAVE.

Suivant les cas, ces composants actifs sont montés en boîtier, sur un support pour puce testable ("chip carrier"), ou directement en puces dans la fonction hyperfréquences.

Dans les deux premiers cas, un test hyperfréquences est réalisé afin de contrôler les performances finales des composants et parce qu'il est plus facile de comprendre l'origine d'un défaut éventuel et de le réparer.

Les fonctions hyperfréquences sont réalisées dans des boîtiers protecteurs étanches ou hermétiques, munis de connecteurs. Un test est parfois effectué avant la fermeture du boîtier pour des réglages finaux et éventuellement des réparations. Ceci s'applique en particulier aux boîtiers complexes ou de performances critiques.

Finalement, le boîtier est fermé, et testé afin de contrôler les performances du sous-ensemble, de l'ensemble, et de l'équipement intégrateur. Il s'agit là de tests dits d'intégration.

Les tests dits in situ sont ceux que l'on pratique en chaque emplacement de la fonction hyperfréquences. D'un point de vue général, les tests in situ sont utiles car il existe un lien direct entre la topologie d'un circuit semi-conducteur et les fonctions électriques réalisées par celui-ci. Plus précisément, on distingue trois niveaux de besoins pour des tests in situ :
- en études ou maquettes, certains couplages entre circuits ou certaines distributions de l'énergie dans les lignes d'alimentation des circuits sont encore mal modélisées, et un outil de mesure de ces énergies permettrait de lever certaines incertitudes de conception ;
- en prototypes, certaines performances ne sont atteintes qu'après réglage. Pour effectuer ces tests, on réalise des boîtiers séparés, que l'on règle et que l'on assemble ensuite. Toutefois cette procédure est coûteuse et de plus ne permet pas de miniaturiser correctement les fonctions hyperfréquences. Un test hyperfréquences in situ permettrait, par exemple, l'adaptation d'amplificateurs montés en cascade sur une céramique, en mesurant la tension existant en un ou plusieurs points des circuits interétages. Un test hyperfréquences in situ permettrait aussi la réalisation de mesures de taux d'ondes stationnaires (TOS) de sortie d'amplificateurs de puissance sans banc de test spécifique ;
- en série, les tests hyperfréquences habituels et les tests sur les alimentations ne permettent pas de localiser les défauts de construction, comme un câblage hyperfréquences défectueux ou même un câblage continu défectueux puisque plusieurs composants sont généralement alimentés en parallèle.

L'objet de l'invention est de pallier les inconvénients précités de l'état de la technique.

En particulier un objectif de l'invention est de proposer un dispositif qui permet de résoudre les problèmes de tests des circuits hybrides fonctionnant dans la gamme des hyperfréquences.

Un autre objectif de l'invention est de proposer un dispositif, pour tests hyperfréquences à large bande réalisés in situ, qui soit d'une manipulation facile pour tester différents endroits d'une fonction hyperfréquence.

Essentiellement, le principe de l'invention consiste en un dispositif destiné à être posé sur le substrat d'un circuit hybride à tester pour capter l'onde électromagnétique rayonnée au-dessus du substrat par le circuit hybride et mesurer un signal. L'invention s'applique donc de préférence aux structures ouvertes telles que lignes microruban, lignes coplanaires ou autres.

Plus spécifiquement, l'invention concerne un dispositif pour tests hyperfréquences à large bande réalisés in situ tel que défini dans les revendications.

D'autres caractéristiques et avantages de l'invention apparaîtront encore mieux à la lecture de la description ci-dessous faite en référence aux dessins dans lesquels :
- la figure 1 représente une vue en perspective du dispositif en fonctionnement pour tests hyperfréquences selon un premier mode de réalisation de l'invention ;
- la figure 2 représente une vue en perspective du dispositif en fonctionnement pour tests hyperfréquences selon un second mode de réalisation de l'invention ;
- la figure 3 représente une vue en perspective du dispositif en fonctionnement pour tests hyperfréquences selon un troisième mode de réalisation de l'invention.

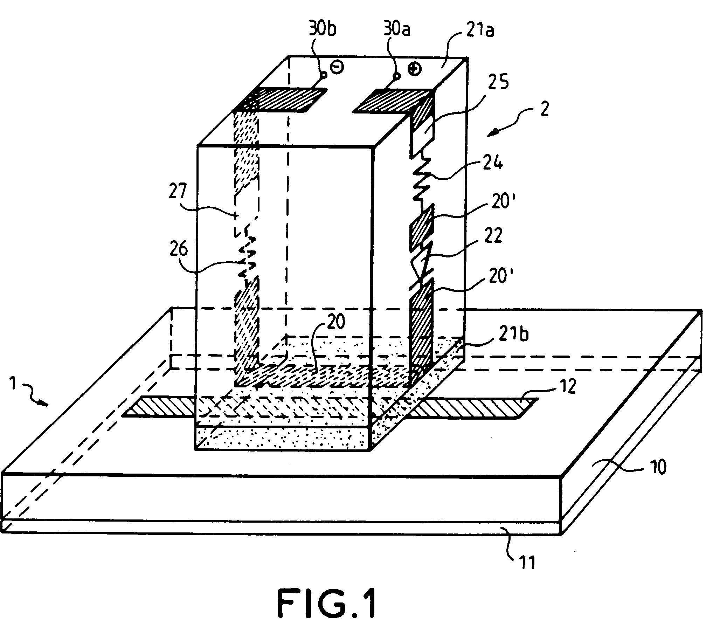

Sur la figure 1, on a représenté une portion 1 d'un circuit hyperfréquence à tester in situ, ce circuit comprenant un substrat 10, par exemple en céramique, un plan de masse 11, et une ligne microstrip 12. En fonctionnement hyperfréquence, la ligne 12 rayonne une onde électromagnétique au-dessus du substrat 10. Le principe de test consiste à prélever par couplage un champ électromagnétique engendré par cette onde et de mesurer ses caractéristiques, à l'aide d'un dispositif 2 que l'on pose directement sur le circuit 1. Pour ce faire, le dispositif 2 selon l'invention comporte, conformément à la figure 1, un support 21a, par exemple en céramique, possédant une face inférieure destinée à être placée au-dessus de la ligne 12, et des moyens de couplage 20 placés sur cette face inférieure. Selon une caractéristique essentielle de l'invention, les moyens de couplage 20 sont recouverts d'une partie isolante 21b dont l'épaisseur permet, lorsque la face de cette partie isolante opposée à celle en contact avec les moyens de couplage 20 est placée en contact avec la ligne 12, de réaliser les conditions d'espacement entre la ligne 12 et les moyens de couplage 20, nécessaires au bon fonctionnement du couplage. Les moyens de couplage 20 sont par exemple réalisés par un conducteur en or déposé par sérigraphie. Le couplage réalisé entre la ligne hyperfréquence 12 et le conducteur, séparés tous deux par la partie isolante 21b, est donc de nature capacitive. La partie isolante peut être par exemple une couche de matériau kapton autocollant, ou encore une lamelle de silice collée sur la partie inférieure du support (21a).

Pour réaliser un bon couplage, l'épaisseur de cette partie isolante est environ de 0,2 mm.

Le dispositif selon l'invention comporte en outre des moyens d'extraction d'une caractéristique du champ électromagnétique prélevé par les moyens de couplage 20. Selon le premier mode de réalisation possible du dispositif présenté par la figure 1, ces moyens d'extraction sont constitués d'une diode de détection 22, par exemple du type Schottky, détectant un signal de courant redressé représentatif du champ électromagnétique, et d'une résistance de protection 24 pour la polarisation de la diode. Une mesure de la tension aux bornes 30a, 30b de la résistance 24 et de la diode 22 permet de tester le bon fonctionnement.

Préférentiellement, les moyens d'extraction sont placés sur le support 21a suffisamment éloignés des moyens de couplage pour ne pas exercer d'action parasite, et avantageusement à un endroit autre que la face inférieure du support 21a.

Pour améliorer les performances du dispositif de tests 2, il est préférable de placer, entre la résistance de polarisation 24 et la borne 30a de mesure de la tension, un absorbant 25, par exemple une mousse chargée de carbone collée sur le support 21a. Le rôle de cet absorbant est d'absorber les ondes hyperfréquences qui risquent de perturber la détection.

Dans cette même optique d'améliorer le fonctionnement du dispositif 2, on peut également placer une autre résistance 26 et un autre absorbant 27 en série avec l'extrémité des moyens de couplage 20 qui n'est pas reliée à la diode de détection 22.

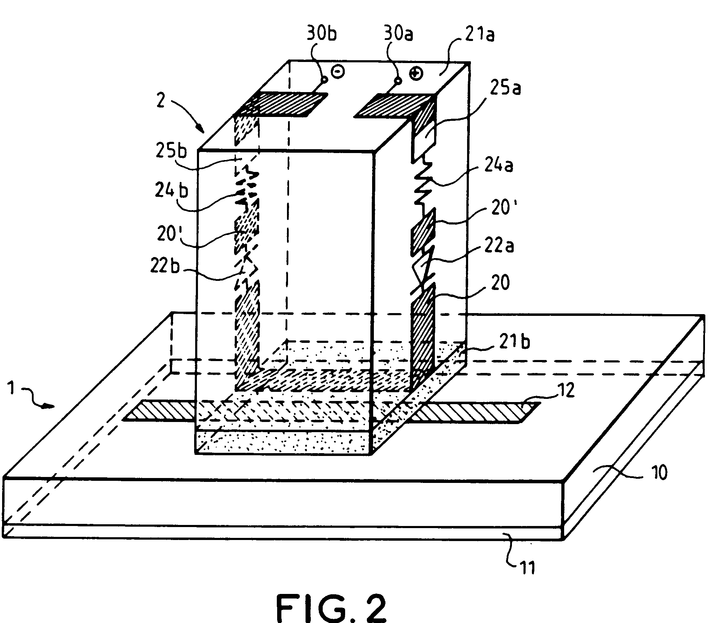

La figure 2 est une seconde variante de réalisation du dispositif de tests selon l'invention. Dans cette seconde variante de réalisation, on rend symétrique le fonctionnement du dispositif en plaçant deux diodes de détection 22a et 22b de part et d'autre des moyens de couplage 20, ces diodes étant placées en série dans le même sens, et polarisées respectivement par les résistances 24a, 24b. Cette disposition plus symétrique permet d'avoir un meilleur comportement. De plus, l'utilisation de deux diodes de détection permet d'obtenir un signal de tension plus important, ce signal étant mesuré, comme dans le cas de la figure 1, aux bornes 30a, 30b, c'est-à-dire aux extrémités libres des deux résistances.

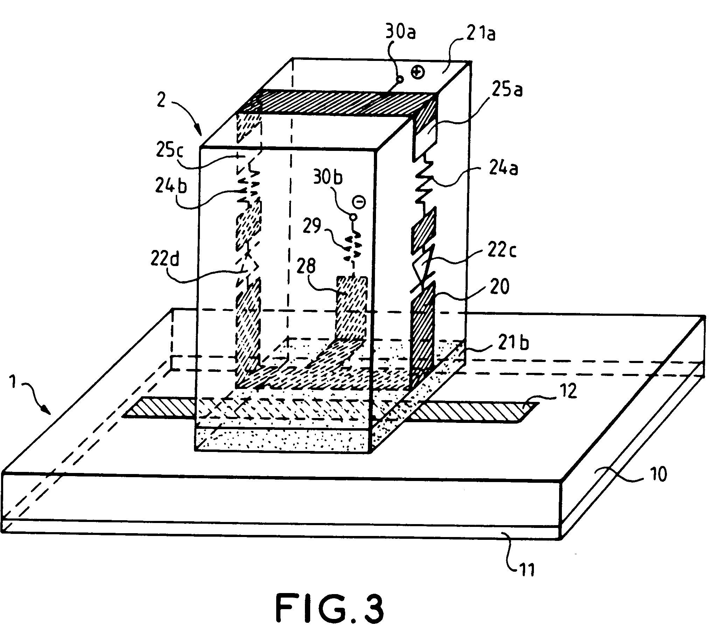

La figure 3 est un troisième mode de réalisation possible du dispositif pour tests selon l'invention, dans lequel on utilise deux diodes de détection selon un montage de type push-pull.

Plus précisément, le dispositif 2 comporte, sur son support 21a, deux diodes 22c, 22d, du type Schottky, placées tête-bêche en parallèle de part et d'autre des moyens de couplage 20. Les deux diodes 22c, 22d sont respectivement polarisées par deux résistances de polarisation 24a, 24b reliées entre elles par leur deuxième extrémité, leur point de contact constituant une des bornes 30a, qui est, dans le cas de la figure 3, la borne positive. On réalise l'autre borne 30b en un point milieu relié aux moyens de couplage 20 par l'intermédiaire d'une ligne conductrice 28, et d'une résistance 29. Ce montage permet d'avoir une impédance plus basse que dans les deux montages précédents. Là encore, un montage symétrique offre de meilleures performances.

Il existe d'autres variantes du dispositif de tests permettant diverses applications.

On peut notamment, sur le montage de la figure 1, insérer un amplificateur monolithique entre les moyens de couplage 20 et la diode de détection 22, et dépose, par sérigraphie, sur le support 21a, des bornes d'alimentation. Ceci permet d'avoir une meilleure sensibillté et d'améliorer l'impédance d'attaque de la diode. On peut notamment utillser ce circuit pour tester des fréquences plus basses.

Il est également possible de placer, sur le support 21a, un système de calibration interne composé par exemple d'une diode, d'une résistance de polarisation de la diode, et d'une source basse fréquence. En fonctionnement, on ajuste la puissance de cette source pour que la tension mesurée soit égale à la tension aux bornes du système de calibration. Lorsque l'égalité est obtenue, on obtient alors une mesure de la puissance hyperfréquence au point testé.

Le dispositif selon l'invention présente le grand avantage de pouvoir être posé directement en différents points du circuit hyperfréquence à tester. Il n'est donc pas nécessaire d'utiliser des moyens mécaniques compliqués pour assurer l'espacement entre les moyens de couplage 20 et la ligne hyperfréquence 12 que l'on teste. Il n'est pas non plus nécessaire de réaliser au préalable des trous métallisés dans le circuit pour récupérer la masse hyperfréquence, comme c'est le cas avec les dispositifs à contacts.

La mesure de la tension aux bornes 30a, 30b des moyens d'extraction s'effectue par tout moyen connu de l'homme du métier (voltmètre, oscilloscope, analyseur scolaire).

## Revendications

1. Dispositif pour tests hyperfréquences à large bande réalisés in situ, du type comportant un support (21a) ayant une face inférieure destinée à être placée au-dessus d'une ligne hyperfréquence (12) rayonnant une onde électromagnétique, et des moyens de couplage hyperfréquence (20) portés par le support (21a) pour capter l'onde électromagnétique et maintenus au-dessus de la ligne avec un espacement suffisant par rapport à cette ligne pour réaliser un couplage hyperfréquence par prélèvement, ledit dispositif étant caractérisé en ce que les moyens de couplage (20) sont placés sur la face inférieure dudit support (21a), en ce qu'ils sont recouverts d'une partie isolante (21b) dont l'épaisseur constitue ledit espacement, la face de la partie isolante opposée à celle en contact avec les moyens de couplage (20) étant placée en contact avec la ligne (12), et en ce que le dispositif comporte des moyens d'extraction (22, 24) d'un signal caractéristique de l'onde prélevée par les moyens de couplage (20), disposés sur le support (21a).

2. Dispositif pour tests hyperfréquences selon la revendication 1, caractérisé en ce que les moyens d'extraction (22, 24) sont reliés aux moyens de couplage (20), sans pour autant être placés sur ladite face inférieure du support.

3. Dispositif pour tests hyperfréquences selon l'une quelconque des revendications 1 et 2, caractérisé en ce que le support (21a) est en céramique, et en ce que les moyens de couplage (20) sont constitués d'un conducteur déposé sur la face inférieure du support (21a).

4. Dispositif pour tests hyperfréquences selon la revendication 3, caractérisé en ce que le conducteur est de l'or sérigraphié.

5. Dispositif pour tests hyperfréquences selon l'une quelconque des revendications précédentes, caractérisé en ce que la partie isolante (21b) est une couche de kapton autocollant.

6. Dispositif pour tests hyperfréquences selon l'une quelconque des revendications 1 à 4, caractérisé en ce que la partie isolante (21b) est une lamelle de silice collée sur la partie inférieure du support (21a).

7. Dispositif pour tests hyperfréquences selon l'une quelconque des revendications précédentes, caractérisé en ce que les moyens d'extraction sont constitués d'une diode de détection (22) in situ d'un signal de courant redressé représentatif du champ électromagnétique de l'onde hyperfréquence, ladite diode étant reliée d'un côté à une extrémité des moyens de couplage (20), et de l'autre à une résistance de protection (24 ; 24a), le signal caractéristique étant la tension aux bornes (30a, 30b) de la résistance et des moyens de couplage.

8. Dispositif pour tests hyperfréquences selon l'une quelconque des revendications 1 à 6, caractérisé en ce que les moyens d'extraction comportent deux diodes de détection (22a, 22b) polarisée chacune par une résistance de polarisation (24a, 24b), les diodes étant reliées de part et d'autre des moyens de couplage (20) de façon à ce que les deux diodes soient en série et dans le même sens, le signal caractéristique étant la tension aux extrémités libres (30a, 30b) des deux résistances.

9. Dispositif pour tests hyperfréquences selon l'une quelconque des revendications 1 à 6, caractérisé en ce que les moyens d'extraction comportent deux diodes de détection (22c, 22d) polarisée chacune par une résistance de polarisation (24a, 24d), les deux diodes étant reliées entre elles, et de part et d'autre des moyens de couplage de façon à être en parallèle et tête-bêche, et un point milieu (30b) relié aux moyens de couplage (20) par l'intermédiaire d'une résistance (29), le signal caractéristique étant la tension entre ledit point milieu (30b) et le point de contact (30a) entre les deux diodes.

10. Dispositif pour tests hyperfréquences selon l'une quelconque des revendications 7 et 8, caractérisé en ce qu'il comporte en outre, pour réaliser des mesures en basse fréquence, un amplificateur monolithique placé entre les moyens de couplage (20) et la diode de détection, ainsi que des bornes d'alimentation de cet amplificateur.

11. Dispositif pour tests hyperfréquences selon la revendication 7, caractérisé en ce qu'il comporte en outre, fixé sur le support (21a), un système de calibration interne composé d'une diode, d'une résistance de polarisation en série avec cette diode et d'une source basse fréquence.
